**Europäisches Patentamt**

(19) **European Patent Office**

**Office européen des brevets**

(11) Publication number : **0 474 564 A1**

(12) # EUROPEAN PATENT APPLICATION

(21) Application number : **91402393.2**

(22) Date of filing : **06.09.91**

(51) Int. Cl.[5] : **H01L 29/73, H01L 21/331**

(30) Priority : **07.09.90 JP 237881/90**
**20.03.91 JP 56506/91**

(43) Date of publication of application :
**11.03.92 Bulletin 92/11**

(84) Designated Contracting States :
**DE FR GB**

(71) Applicant : **FUJITSU LIMITED**
**1015, Kamikodanaka Nakahara-ku**
**Kawasaki-shi Kanagawa 211 (JP)**

(72) Inventor : **Gotou, Hiroshi, c/o FUJITSU**
**LIMITED**
**1015, Kamikodanaka, Nakahara-ku**
**Kawasaki-shi, Kanagawa 211 (JP)**

(74) Representative : **Joly, Jean-Jacques et al**
**CABINET BEAU DE LOMENIE 55, rue**
**d'Amsterdam**
**F-75008 Paris (FR)**

(54) **Lateral bipolar transistor having electrically induced emitter and collector regions.**

(57) A lateral bipolar transistor comprises a device layer (28) doped to a first conductivity type, first and second diffusion regions (32, 33) doped to a second conductivity type and formed in the device layer with a separation from each other, a base region (31) defined in the device layer between the first and second diffusion regions as a part of the device layer with a separation from the first and second diffusion regions, an intervening region (32A, 33A) formed in the device layer at both sides of the base region, and a control gate structure (29, 29a, 30) provided in correspondence to the intervening region, for inducing an inversion layer in the device layer in correspondence to the intervening region as the emitter and collector of the bipolar transistor.

# FIG.2B

EP 0 474 564 A1

## BACKGROUND OF THE INVENTION

The present invention generally relates to semiconductor devices and more particularly to a lateral bipolar transistor having the emitter and collector regions formed as inversion layers.

Conventionally, the so-called SOI (silicon-on-insulator) devices are studied extensively in relation to the devices that are capable of operating under radioactive environment or in relation to the high speed devices having reduced parasitic capacitance and increased integration density. In relation to the SOI devices, a vertical bipolar transistor is proposed wherein the emitter region and the collector region are formed from inversion layers that in turn are formed in the semiconductor layer as a result of the application of an electric field. See for example J.C. Strum et al. "Vertical Bipolar Transistor in Silicon-on-Insulator," NAVY TECHNICAL DISCLOSURE BULLETIN vol.12, no.2, December 1986, which is incorporated herein as reference.

Such a bipolar transistor using the inversion layers for the emitter and collector regions, has various preferable features such as increased current gain due to the reduced resistance of the collector and emitter regions, capability of controlling the current gain by the voltage that is used for inducing the inversion layers, reduced parasitic capacitance of the collector region, and the like.

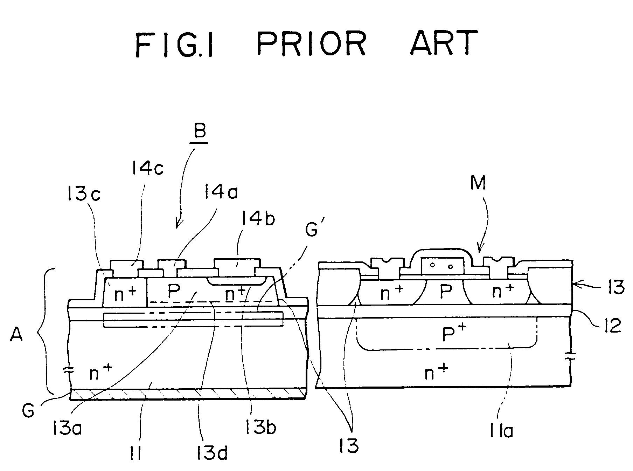

FIG.1 shows the conventional vertical bipolar transistor of the SOI construction that uses the inversion layers for the emitter and collector regions.

Referring to FIG.1, the lateral bipolar transistor is constructed on an SOI substrate A that includes a support substrate 11 of the $n^+$-type and an insulating substrate 12 is formed on the substrate 11. On the surface of the substrate 12, a semiconductor layer 13 is provided as the device layer. In the illustrated example, a vertical bipolar transistor B and a MOS transistor M are formed on the device layer 13. In the bipolar transistor B, a p-type base region 13a is formed by the device layer 13, and an $n^+$-type emitter region 13b formed in correspondence to a surface part of the base layer 13a. Further, a collector contact region 13c of the $n^+$-type is provided within the device layer 13 with a separation from the base region 13b such that the region 13c extends from the upper major surface to the lower major surface of the device layer 13. The MOS transistor M on the other hand is formed on a p-type well 11a formed in the support substrate 11.

In the bipolar transistor B, a base electrode 14a is provided in correspondence to the upper major surface of the base layer 13a. Similarly, an emitter electrode 14b is provided in correspondence to the emitter region 13b. Further, a collector electrode 14c is provided in correspondence to the collector contact region 13c. Thus, the bipolar transistor B has the well known vertical construction except that the collector region is not included. Instead, the transistor B of FIG.1 has a backgate electrode G at the lower major surface of the support substrate 11. By applying a suitable positive voltage to the backgate electrode G, an inversion layer 13d is induced along the lower major surface of the base layer 13a as illustrated in FIG.1. Thereby, the inversion layer 13d acts as the collector region of the bipolar transistor. Instead of providing the backgate electrode G, one may provide a gate electrode G' immediately below the insulating substrate 12.

In the bipolar transistor using the inversion layer as the collector region, one can obtain various preferable features such as the control the current gain of the transistor by the control voltage applied to induce the inversion layer. By suitably choosing the control voltage, the current gain may be maximized. Further, one can reduce the parasitic capacitance of the collector region.

In the conventional vertical bipolar transistor of FIG.1, however, there has been a problem that one has to achieve an exact alignment between the backgate electrode G and the device region in which the transistor is formed. Thereby, a difficulty arises particularly when the size of the device is miniaturized. Further, the application of the bias voltage to the backgate electrode G may cause an unwanted effect on the operation of the MOS transistor M that is formed on the common support substrate 11. In order to avoid this problem, one has to use the $p^+$-type well 11a in correspondence to the channel region of the MOS transistor M. Again, one encounters difficulty in establishing the proper alignment between the well 11a and the channel region of the MOS transistor M. Further, when the backgate electrode G' is used as shown in FIG.1, one needs a complex insulation structure.

## SUMMARY OF THE INVENTION

Accordingly, it is a general object of the present invention to provide a novel and useful bipolar transistor wherein the foregoing problems are eliminated.

Another and more specific object of the present invention is to provide a lateral bipolar transistor that uses inversion layers as the emitter and collector of the transistor, wherein the fabrication of the transistor is simplified and the yield of fabrication improved.

Another object of the present invention is to provide a lateral bipolar transistor that is suited for fabrication on a common substrate together with MOS transistors.

Another and more specific object of the present invention is to provide a lateral bipolar transistor comprising a semiconductor layer acting as a base region and a pair of diffusion regions formed in the semiconductor layer at both lateral sides of the base region as the collector contact and emitter contact regions, wherein an induction electrode is provided on an upper major surface of the semiconductor layer, via an oxide film, in correspondence to an emitter and a collector of the bipolar transistor such that inversion layers are formed as the emitter and the collector. According to the present invention, one can form the entire electrodes including the induction electrode, on the upper major surface of the substrate, and the problem of the alignment needed at the time of fabrication of the device of FIG.1 is eliminated. Thereby, the fabrication of the device becomes easier and the yield of production is improved. As the induction electrode is insulated from the semiconductor layer acting as the base as well as the collector and emitters of the bipolar transistor, the application of the voltage to the induction electrode for inducing the inversion layers does not cause any problem in the operation of any other transistors such as the MOS transistors that are formed on the same substrate. Further, by providing an additional electrode on the oxide film in correspondence to the base region, one can modify the carrier density in the base region and hence the base resistance as desired in response to a control voltage applied to the additional electrode. Thereby, one can control the amplification factor of the bipolar transistor as desired.

Other objects and further features of the present invention will become apparent from the following detailed description for the preferred embodiments when read in conjunction with the attached drawings.

## BRIEF DESCRIPTION OF THE DRAWINGS

FIG.1 is a diagram showing a conventional vertical bipolar transistor that uses an inversion layer as the collector of the transistor;

FIGS.2(A) and 2(B) are diagrams respectively showing a lateral bipolar transistor of a first embodiment of the present invention in the plan view and in the cross sectional view;

FIGS.3(A) - 3(D) are diagrams showing the process for fabricating the lateral bipolar transistor of the first embodiment;

FIGS.4(A) and 4(B) are diagrams respectively showing a lateral bipolar transistor of a second embodiment of the present invention in the plan view and in the cross sectional view;

FIGS.5(A) - 5(G) are diagrams showing the process for fabricating the lateral bipolar transistor of the second embodiment;

FIGS.6(A) and 6(B) are diagrams respectively showing a lateral bipolar transistor of a third embodiment of the present invention in the plan view and in the cross sectional view;

FIGS.7(A) - 7(D) are diagrams respectively showing the process for fabricating the lateral bipolar transistor of the third embodiment;

FIGS.8(A) and 8(B) are diagrams respectively showing a lateral bipolar transistor of a fourth embodiment of the present invention in the plan view and in the cross sectional view;

FIGS.9(A) - 9(D) are diagrams showing the process for fabricating the lateral bipolar transistor of the fourth embodiment;

FIGS.10(A) and 10(B) are diagrams respectively showing a lateral bipolar transistor of a fifth embodiment of the present invention in the plan view and in the cross sectional view;

FIGS.11(A) - 11(D) are diagrams showing the process for fabricating the lateral bipolar transistor of the fifth embodiment;

FIGS.12(A) and 12(B) are diagrams respectively showing a lateral bipolar transistor of a sixth embodiment of the present invention in the plan view and in the cross sectional view;

FIGS.13(A) and 13(B) are diagrams respectively showing a lateral bipolar transistor of a seventh embodiment of the present invention in the plan view and in the cross sectional view;

FIGS.14(A) - 14(H) are diagrams showing the process for fabricating a lateral bipolar transistor according to an eighth embodiment of the present invention;

FIGS.15(A) and 15(B) are diagrams showing a modification of the fabrication process of the eighth embodiment;

FIG.16 is a diagram showing another modification of the eighth embodiment;

FIGS.17(A) and 17(B) are diagrams showing still another modification of the eighth embodiment;

FIGS.18(A) - 18(C) are diagrams showing still another modification of the eighth embodiment;

FIGS.19(A) and 19(B) are equivalent circuit diagrams of the lateral bipolar transistor of the present invention; and

FIG.20(A) and 20(B) are diagrams showing the operational characteristics of the device of FIGS.2(A) and 2(B).

## DETAILED DESCRIPTION

Hereinafter, preferred embodiments of the present invention will be described.

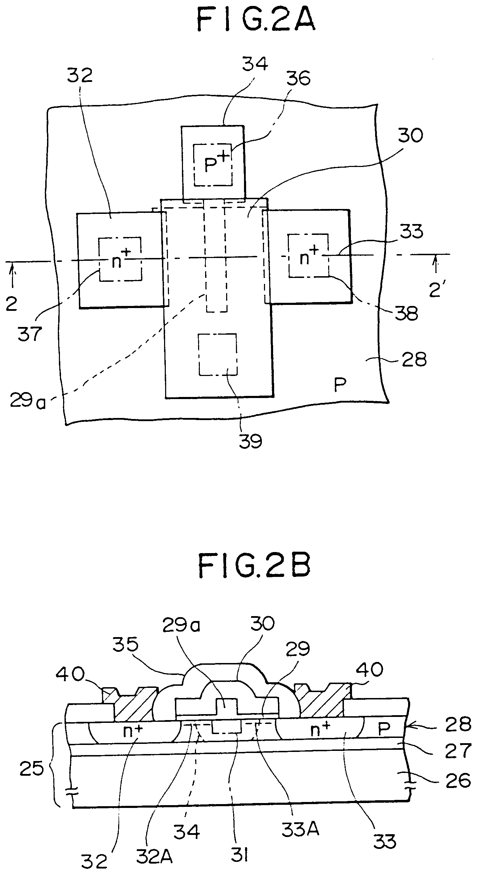

Referring to FIGS.2(A) and 2(B) showing a first embodiment respectively in the plan view and in the cross sectional view taken along the cross section 2-2' of FIG.2(A), the lateral bipolar transistor is constructed on an SOI substrate 25 that includes a support substrate 26 of p-type silicon, a silicon oxide layer 27 formed on the upper major surface of the support substrate with a thickness of about 1 μm, and a device layer 28 of p-type silicon formed on the upper major surface of the silicon oxide layer 27 with a thickness of about 500 nm. As will be understood from the following description, the conductivity type of the support substrate 26 is not essential in the present embodiment.

On the surface of the device layer 28, a silicon oxide film 29 having a projection 29a is provided, and an induction electrode 30 is provided to cover the silicon oxide film 29 including the projection 29a. In correspondence to the projection 29a, a base region 31 of the p-type is formed in the device layer 28 as will be described below, and an $n^+$-type emitter contact region 32 and an $n^+$-type collector contact region 33 are formed also in the device layer 28 at both sides of the induction electrode 30 and hence at both sides of the base region 31. The emitter contact region 32 and the collector contact region 33 extend continuously from the upper major surface to the lower major surface of the device layer 28.

In response to an application of a suitable control voltage, the induction electrode 30 induces inversion layers 32A and 33A in the device layer 28 respectively between the base region 31 and the emitter contact region 32 and between the base region 31 and the collector contact region 33. It should be noted that the formation of the inversion layer does not occur in the base region 31 because of the projection 29a that increases the distance between the induction electrode 30 and the device layer 28. In other words, the base region 31 is formed as a region of the device layer 28 that is free from the formation of the inversion layer. In such a structure, a free transport of the carriers is achieved between the emitter contact 32 and the collector contact 33 via the base region 31.

On the induction electrode 30, an insulation layer 35 of silicon oxide is deposited as shown in the cross sectional view of FIG.2(B), and the emitter contact region 32 and the collector contact region 33 are exposed via respective contact holes. Further, polysilicon electrodes 40 are provided in correspondence to the respective contact holes to establish an ohmic contact with the emitter contact region 32 and the collector contact region 33. Further, a base region 31 extends laterally along the projection 29a as shown in FIG.2(A), and a $p^+$-type base contact region 34 is formed in the device layer 28 with an offset from the cross section of FIG.2(B). In FIG.2(B), the base contact region 34 is formed with an offset in the downward direction to the sheet of the drawing. Further, the induction electrode 30 extends laterally in the plan view of FIG.2(A) and a contact hole 39 is provided for external connection. In the cross sectional view of FIG.2(B), the induction electrode 30 extends vertically to the sheet of the drawing and the contact hole 39 is provided with an offset in the upward direction from the level of the sheet of the drawing.

In operation, the voltage level of the collector contact region 33 is held higher than the voltage level of the emitter contact region 32. Further, a positive voltage is applied to the induction electrode 30. In response to this, the inversion layers 32A and 32B are formed as already described as the emitter and the collector of the bipolar transistor. On the other hand, no inversion layer is formed in the base region 31 because of the increased distance between the induction electrode 30 and the device layer 28. Thus, the electrons that are injected to the emitter contact region 32 are transferred to the base region 31 via the inversion layer 32A. Further, the electrons are transferred to the collector region from the base region 31 via the inversion layer 33A. Thus, the collector current of the transistor is controlled in response to the base current of the base region 31 similar to the conventional bipolar transistor.

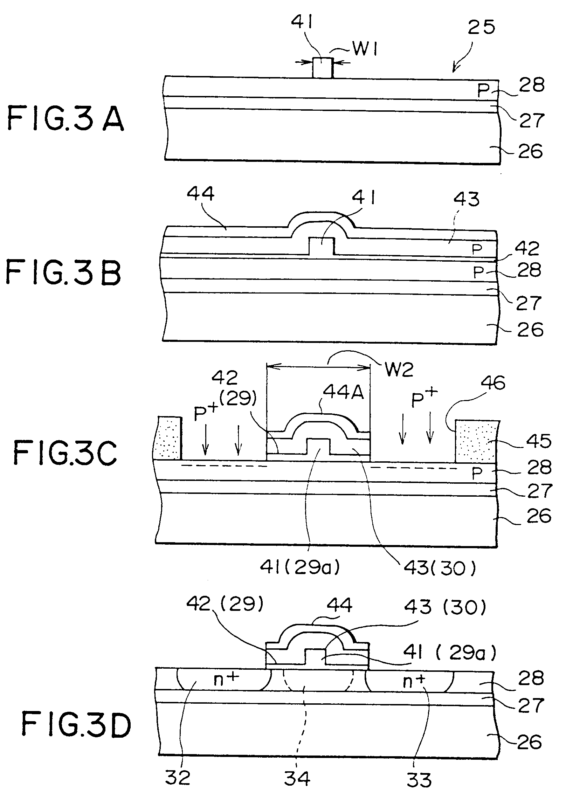

Next, the fabrication process of the lateral bipolar transistor of FIGS.2(A) and 2(B) will be described with reference to FIGS.3(A) - 3(D).

Referring to FIG.3(A), a first silicon oxide layer (not shown) is deposited on the upper major surface of the device layer 28 forming the uppermost layer of the SOI substrate 25 by the CVD process, with a thickness of about 500 nm. After patterning the first silicon oxide layer, a silicon oxide ridge 41 is left on the upper major surface of the device layer 28 as illustrated in FIG.3(A) with a width W1 of about 1 μm.

Next, the surface of the device layer 28 is subjected to a thermal oxidation process conducted in the dry oxygen environment such that a second silicon oxide film 42 is formed in continuation with the silicon oxide ridge 41 with a thickness of about 10 nm as shown in FIG.3(B). Further, a polysilicon layer 43 and a third silicon oxide layer 44 are deposited on the second silicon oxide film 42 consecutively with the thicknesses of 500 nm and 300 nm, respectively. Thereby, a structure shown in FIG.3(B) is obtained.

Next, the polysilicon layer 43 as well as the silicon oxide layers 42 and 44 are subjected to a patterning process as shown in FIG.3(C) such that an induction gate structure 44A is formed generally symmetric with respect to the ridge 41 with a width W2 of about 3 μm or less. Thereby, the polysilicon layer 43 left in the induction gate structure 44A acts as the induction electrode 30, and the ridge 41 acts as the projection 29a. Further, a photoresist 45 is applied and patterned subsequently to form a window that exposes the region of the device layer 28 serving for the emitter contact region 32 and the collector contact region 33. Further, using the patterned photoresist as the mask, an ion implantation process of arsenic or phosphorus is conducted via the window 46 with a dose of 5 X $10^{15}/cm^2$ to form the emitter contact region 32 and the collector contact region 33. After the ion implantation, the photoresist 45 is removed.

Subsequent to the formation of the emitter and collector contact regions, the base contact region 34 is formed by the ion implantation of boron with the dose of 5 X $10^{12}/cm^2$. This process may be accomplished before the formation of the emitter and collector contact regions 32 and 33.

Further, the structure thus obtained is applied with an annealing process such that the implanted dopants are activated in the respective regions, and the structure shown in FIG.3(D) is obtained wherein the emitter contact region 32 and the collector contact region 33 are formed at both ends of the induction gate structure 44. Further, the insulation layer 35 of silicon oxide or PSG is applied on the structure of FIG.3(D) and contact holes 36, 37, 38 and 39 are formed respectively in correspondence to the base contact region 34, the emitter contact region 32, the collector contact region 33 and the induction gate electrode 30 as shown in the plan view of FIG.2(A). By providing the electrodes 40 in correspondence to each of the contact holes, the structure shown in FIG.2(B) is obtained.

In the present embodiment, the induction electrode 30 is formed at the upper side of the substrate during the process for forming the base, emitter and the collector regions. In fact, the emitter region 32 and the collector region 33 are formed in alignment with the gate structure 44A in accordance with the self-alignment process. Thus, the process for forming a backgate electrode in alignment with the base region as in the conventional device of FIG.1 is eliminated and the fabrication of the device becomes significantly easier. This in turn improves the yield and reduces the cost of the device. Further, the application of the bias voltage for forming the inversion layers 32A and 33A is not made directly to the substrate but is made via the silicon oxide film 29. Thereby, the potential of the substrate itself is not changed, and the operation of other devices formed on the same substrate such as the MOS transistors is not affected even when the bias voltage is applied.

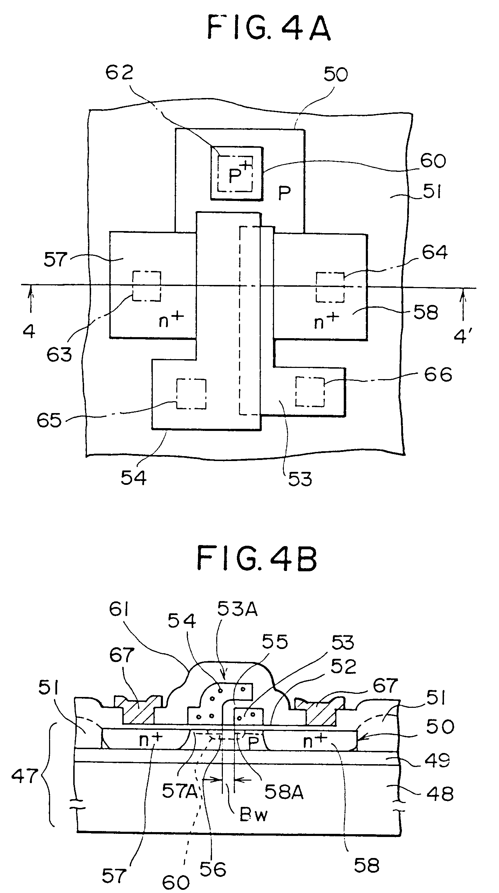

Next, a second embodiment of the present invention will be described with reference to FIGS.4(A) and 4(B), wherein FIG.4(A) shows a plan view and FIG.4(B) shows a cross sectional view taken along a cross section 4-4'.

In the present embodiment, the bipolar transistor is constructed on an SOI substrate 47 similar to the substrate 25 of the first embodiment, wherein the substrate 47 includes a silicon support substrate 48, a silicon oxide insulation layer 49 formed on the substrate 48, and a device layer 50 of p-type silicon grown on the insulation layer 49. Further, a device isolation region 51 of silicon oxide is formed in the device layer 50 to surround a device region defined in the device layer 50 for constructing the bipolar transistor. The device isolation region 51 is formed by the selective thermal oxidation of the device layer 50 and extends from the upper major surface to the lower major surface of the layer 50. It should be noted that the upper major surface of the device layer 50 is represented in the cross sectional view of FIG.4(B) by a broken line. This upper major surface is no longer flat after the thermal oxidation because of the dilatation caused as a result of the oxidation of silicon.

The upper major surface of the device layer 50 is covered by a thin silicon oxide film 52 typically of a thickness of about 10 nm. Further, first and second induction electrodes 53 and 54 are formed on the upper major surface of the silicon oxide film 52 to extend generally parallel with each other along the upper major surface of the silicon oxide film 52. See the plan view of FIG.4(A). The induction electrode 54 forms an overhang structure that covers the induction electrode 53 partially, with a separation therefrom. Thereby, the induction electrodes 53 and 54 are separated laterally from each other on the upper major surface of the silicon oxide film 52 by a minute gap that is filled by a silicon oxide film 55. The silicon oxide film 55 typically has a thickness of about 200 nm. Thus, the electrodes 53 and 54 are separated from each other laterally by a distance of about 200 nm. In correspondence to the gap, a base region 56 is formed in the device layer 50. Thereby, the induction electrodes 53 and 54 form a gate structure 53A together with the silicon oxide film 55.

At a first side of the gate structure 53A, an $n^+$-type emitter contact region 57 is formed in the device layer 50 to extend continuously from the upper major surface to the lower major surface of the device layer 50. Similarly, an $n^+$-type collector contact region 58 is formed in the device layer 50 at an opposite side of the gate structure 53A to extend continuously from the upper major surface to the lower major surface of the device layer 50. Similar to the first embodiment, an inversion layer 57A is formed in the device layer 50 as the emitter of the bipolar transistor in correspondence to the part of the layer 50 that is located immediately below the induction electrode 54. Further, an inversion layer 58A is formed in the device layer 50 as the collector of the transistor in correspondence to the part that is located immediately below the induction electrode 53. Thereby, there is formed a path of the carriers from the emitter contact region 57 to the base region 56 through the inversion layer 57A, and from the base region 56 to the collector region through the inversion layer 58A.

Further, a base contact region 60 corresponding to the base contact region 34 of the first embodiment is formed in the device layer 50 as shown in FIG.4(A) as a $p^+$-type diffusion region having a thickness of about 200 nm. In the plan view of FIG.4(B), the base contact region 60 is formed at a position offset in the downward direction from the sheet of the drawing.

As shown in FIG.4(B), the bipolar transistor is covered by a silicon oxide insulation layer 61 that buries the gate structure 53A. Further, to establish contact to various parts of the bipolar transistor, contact holes 62, 63 and 64 are formed respectively in correspondence to the base contact region 60, the emitter contact region 57 and the collector contact region 58. The actual contact is achieved by aluminum or polysilicon electrodes 67 shown in FIG.4(B) that fill these contact holes.

In this embodiment, too, the emitter region and the collector region of the bipolar transistor is provided by the inversion layers 57A and 58A that in turn are induced as a result of application of a control voltage to the induction electrodes 53 and 54. In the present embodiment, it should be noted that the width Bw of the base region 56 can be reduced significantly because of the overhang construction of the induction electrodes 53 and 54. As already noted, the width of the gap between the electrodes 53 and 54 can be reduced to about 200 nm in correspondence to the thickness of the insulator film 55. Thus, the time needed for the carriers to transit through the base region 56 is significantly reduced and a high operational speed of the device is obtained.

Next, the fabrication process of the bipolar transistor of the second embodiment will be described with reference to FIGS.5(A) - 5(G).

In the step of FIG.5(A), the device layer 50 of the SOI substrate 47 is applied with a thermal oxidation process such that a silicon oxide film 68 is formed on the surface of the device layer 50 with a thickness of about 10 nm. Further, a silicon nitride film 69 is deposited on the silicon oxide film 68 to protect the device region from oxidation. Further, using the silicon oxide film 69 as the mask, the silicon device layer 50 is subjected to a thermal oxidation process conducted under the wet oxygen environment such that the part of the device layer 50 not protected by the silicon nitride film 69 is completely converted to silicon oxide. Thereby, the field oxide region 51 is formed for device isolation as shown in FIG.5(A).

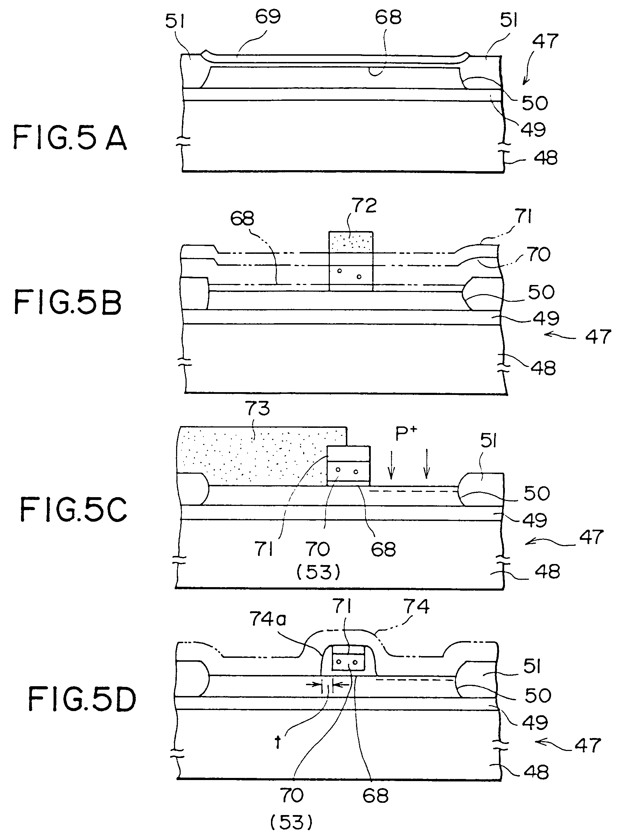

Next, the silicon nitride film 69 is removed by the etching in a phosphorous acid to expose the upper major surface of the device layer 50, and a polysilicon layer 70 and a silicon oxide layer 71 are deposited consecutively on the exposed upper major surface of the device layer 50 by the CVD process respectively with the thickness of 500 nm and 300 nm. After the deposition of the layers 70 and 71, a resist mask 72 is formed to cover the silicon oxide layer generally in correspondence to the central part of the device region as shown in FIG.5(B). The resist mask 72 extends generally perpendicular to the sheet of FIG.5(B). Further, by using the resist mask 72, an etching process is applied such that the silicon oxide layer 71, the polysilicon layer 70 and the thermal oxidation film 68 are removed except for those located immediately below the mask 72. Thereby, the polysilicon layer 70 is patterned into an elongated strip extending perpendicular to the sheet of the drawing. This patterned polysilicon layer 70 acts as the first induction electrode 53 and carries thereon the patterned silicon oxide layer 71.

Next, the resist mask 72 is removed and another resist 73 is provided such that the resist 73 covers the emitter region to be formed in the device layer 50.

Further, while using the resist 73 as well as the patterned polysilicon layer 70 as the mask, an ion implantation of phosphorus or arsenic is achieved into the exposed part of the device layer 50 with the dose of $5 \times 10^{15}/cm^2$. See FIG.5(C). Further, an ion implantation of boron is achieved to form the base contact region 60. As already noted, the base contact region 60 is formed at a part of the device layer 50 that is located below the sheet of drawing in the illustration of FIG.5(C). Typically, the boron ions are implanted with the dose of $1 \times 10^{13}/cm^2$.

Next, the resist mask 73 is removed, and a silicon oxide layer 74 is deposited on the structure thus obtained by the CVD process as shown in FIG.5(D) with a thickness of about 300 nm. Further, the structure thus obtained is subjected to an anisotropic etching process such as the reactive ion etching process such that the silicon oxide layer 74 is etched in the direction perpendicular to the upper major surface of the layer 74. As a result of this anisotropic etching process, a side wall part 74a of silicon oxide is left in correspondence to the side wall of the patterned polysilicon layer 70 as shown in FIG.5(D). Typically the side wall part 74a has a thickness t of about 200 nm in the lateral direction as illustrated in FIG.5(D).

Further, the structure of FIG.5(D) is subjected to a thermal oxidation process conducted in a dry oxygen atmosphere such that a thermal oxidation film 75 is formed with the thickness of about 10 nm in continuation with the side wall part 74a and the silicon oxide layer 71 left on the top surface of the patterned polysilicon layer 70. It should be noted that the thermal oxidation film 75 corresponds to the silicon oxide insulation film 52 of FIG.4(B). Further, the patterned, strip-like polysilicon layer 70 forms the first induction electrode 53 as already noted. Further, a polysilicon layer 76 and a silicon oxide layer 77 are deposited consecutively on the structure thus obtained with respective thicknesses of about 500 nm and about 300 nm as shown in FIG.5(E).

In the step of FIG.5(F), the layers 76 and 77 are patterned as illustrated such that the polysilicon layer 76 and the silicon oxide layer 77 extend vertically to the sheet of the drawing of FIG.5(F). Thereby, the overhang structure of the second induction electrode 54 is formed by the polysilicon layer 76.

Further, in the step of FIG.5(F), the ion implantation of phosphorus or arsenic is conducted again, using the polysilicon electrodes 70 and 76 as the mask. Thereby, the part of the device layer 50 corresponding to the emitter contact region 57 as well as the part of the device layer 50 corresponding to the collector contact region 58 are doped to the n-type. It should be noted that the collector contact region 58 is already doped by the ion implantation process in the step of FIG.5(C).

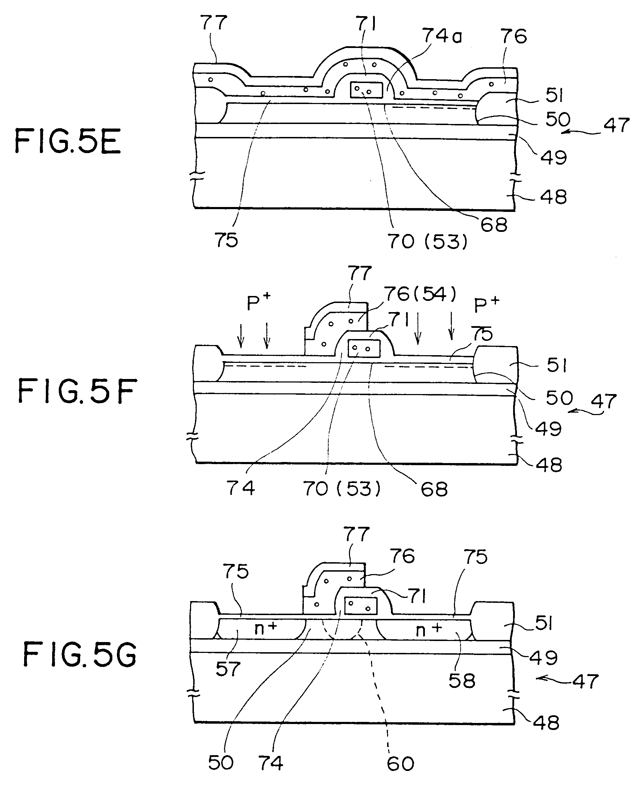

Further, a heat treatment process is applied to the structure thus obtained, and the $n^+$-type diffusion regions are formed respectively in correspondence to the emitter contact region 57 and the collector contact region 58 as shown in FIG.5(G). Simultaneously to the formation of the n⁺-type diffusion regions 57 and 58, the p⁺-type diffusion region 60 is formed as the base contact region. After the structure of FIG.5(G) is formed, the insulation layer 61 is deposited and patterned as shown in FIGS.4(A) and 4(B) to form the contact holes 62 - 66. By filling the contact holes thus formed by the polysilicon or aluminum electrode 67, the structure shown in FIG.4(B) is obtained.

As described previously, the device of the present invention is characterized by the reduced base width Bw that is determined by the thickness t of the silicon oxide side wall part 74a. See FIG.5(D). Thus, the transit time of the carriers through the base region 56 is significantly reduced as described previously and the transistor shows a high operational speed.

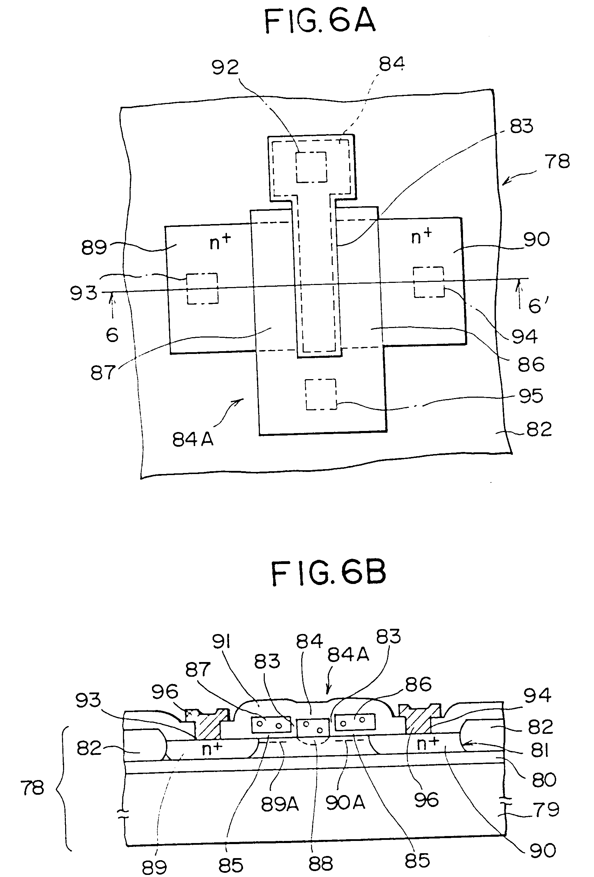

Next, a third embodiment of the present invention is provided with reference to FIGS.6(A) and 6(B), wherein FIG.6(A) shows a plan view and FIG.6(B) shows a cross sectional view taken along a line 6-6′ of FIG.6(A).

Referring to the drawings, the semiconductor device is constructed on a SOI substrate 78 that includes a support substrate 79, a silicon oxide insulation layer 80 grown on the support substrate 79, and a device layer 81 of p-type silicon. Similar to the second embodiment, a field oxide region 82 is formed in the device layer 81 to surround the device region in which the bipolar transistor is formed. The field oxide region 82 may be formed by the selective oxidation of the device layer 81 in the wet oxygen environment.

At the generally central part of the device region, there is formed a polysilicon base electrode 84 in contact with the upper major surface of the device layer 81. The electrode 84 extends laterally along the upper major surface of the device layer 81 as shown in the plan view of FIG.6(A), and a contact hole 92 is formed at a part thereof offset from the device region. In correspondence to the electrode 84, there is formed a base layer 88 of the p⁺-type in the device layer 81.

At both sides of the base electrode 84, a silicon oxide film 85 is provided to cover the upper major surface of the device layer 81, and induction electrodes 86 and 87 are provided on the silicon oxide film 85 to extend laterally along the silicon oxide film 85 at both sides of the base electrode 84. See the plan view of FIG.6(A). In the cross sectional view of FIG.6(B), the induction electrodes 86 and 87 extend vertical to the sheet of the drawing. The electrodes 86 and 87 merge as shown in FIG.6(A), and a contact hole 95 is formed at the part where the electrodes 86 and 87 branch from each other. In the cross sectional view of FIG.6(B), the contact hole 95 is located at the level above the sheet of the drawing. It should be noted that the base electrode 84 as well as the electrodes 86 and 87 form an electrode structure 84A in which the electrode 84 is separated from the electrodes 86 and 87 by a silicon oxide film 83 that may have a thickness of about 20 nm.

At both sides of the electrode structure 84A and hence at both sides of the base region 88, an emitter contact region 89 and a collector contact region 90 are formed in the device layer 81 as the n⁺type diffusion regions. As shown in the cross sectional view, the emitter contact region 89 extends continuously from the upper major surface to the lower major surface of the device layer 81. Similarly, the collector contact region 90 extends continuously from the upper major surface to the lower major surface of the device layer 81. Thereby, the induction electrode 87 covers the region of the device layer 81 that is located between the emitter contact region 89 and the base region 88 and induces an inversion layer 89A in response to the application of a suitable positive bias voltage to the contact hole 95. Similarly, the induction electrode 86 covers the region of the device layer 81 that is located between the collector contact region 90 and the base region 88 and induces an inversion layer 90A in response to the application of the bias voltage at the contact hole 95. Similar to the foregoing embodiments, these inversion layers 89A and 90A serve for the emitter region and the collector region of the bipolar transistor.

Further, the induction electrodes 86 and 87 are buried together with the base electrode 88 under a silicon oxide or PSG layer 91 that is formed with contact holes 93 and 94 respectively in correspondence to the emitter contact region 89 and the collector contact region 90. The contact holes 93 and 94 are filled by a polysilicon or aluminum electrode 96 as shown in the cross sectional view of FIG.6(B). It should be noted that the contact holes 92 and 95 for the base electrode 84 and the induction electrodes 86 and 87 are also formed to penetrate through the insulation layer 91 and filled by the electrode 96.

In this embodiment, too, the emitter and collector regions are provided by the inversion layers 89A and 90A as already described, and various of the preferable features of the foregoing embodiments are achieved.

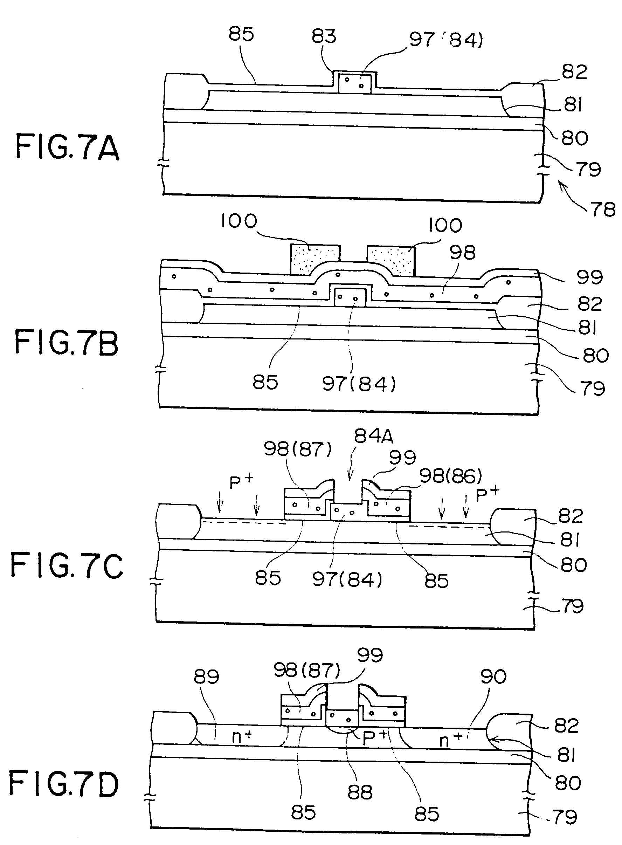

Next, the fabrication process of the device of the present embodiment will be described with reference to FIGS.7(A) - 7(D).

In the step of FIG.7(A), the field oxide region 82 is formed in the device layer 81 similar to the process of FIG.5(A). After the field oxide region 82 is formed, a polysilicon layer 97 of the p-type is deposited by the CVD process with a thickness of about 500 nm. After a photolithographic patterning process of the polysilicon layer 97, the base electrode 84 is formed. Further, the surface of the polysilicon base electrode 84 is subjected to a thermal oxidation process to form the silicon oxide layer 85 that covers the surface of the device layer 81 uniformly with the thickness of about 20 nm. The silicon oxide layer 85 continues to the silicon oxide layer 83 that covers the side wall of the base electrode 84. In fact, the silicon oxide layer 83 and the silicon oxide layer 85 are formed simultaneously by the foregoing thermal oxidation process. Thereby the structure of FIG.7(A) is formed.

Next, a polysilicon layer 98 and a silicon oxide layer 99 are deposited on the structure of FIG.7(A) consecutively with the thicknesses of about 500 nm and 300 nm respectively by the CVD process. Further, a photoresist is applied on the silicon oxide layer 99 and patterned to leave a photoresist region 100 in correspondence to the induction electrodes 86 and 87. See the structure of FIG.7(B).

Next, an anisotropic etching process is applied to remove the silicon oxide layer 99 and the polysilicon layer 98 except for those protected by the photoresist region 100. Thereby, the electrode structure 84A including the induction electrodes 86 and 87 are formed by the polysilicon layer 98 that is left unetched under the photoresist region 100. See FIG.7(C). Further, while using the electrode structure 84A as the mask together with a photoresist pattern (not shown) covering the base electrode 84, an ion implantation of phosphorus or arsenic is conducted into the device layer 81 in correspondence to the emitter contact region 89 and the collector contact region 90.

Next, the photoresist pattern covering the base electrode 84 is removed and an annealing process is conducted to activate the dopants introduced in the foregoing ion implantation process. Thereby, a structure shown in FIG.7(D) is obtained. It should be noted that the base region 88 is formed from the p-type dopants that are released from the polysilicon layer 97 acting as the base electrode 84. After this, the insulation layer 91 is provided to cover the entire surface of the structure of FIG.7(D) and the contact holes 92 - 95 are formed as shown in the plan view of FIG.6(A). Further, the contact holes are filled by the electrode 96 and the structure of FIG.6(B) is formed.

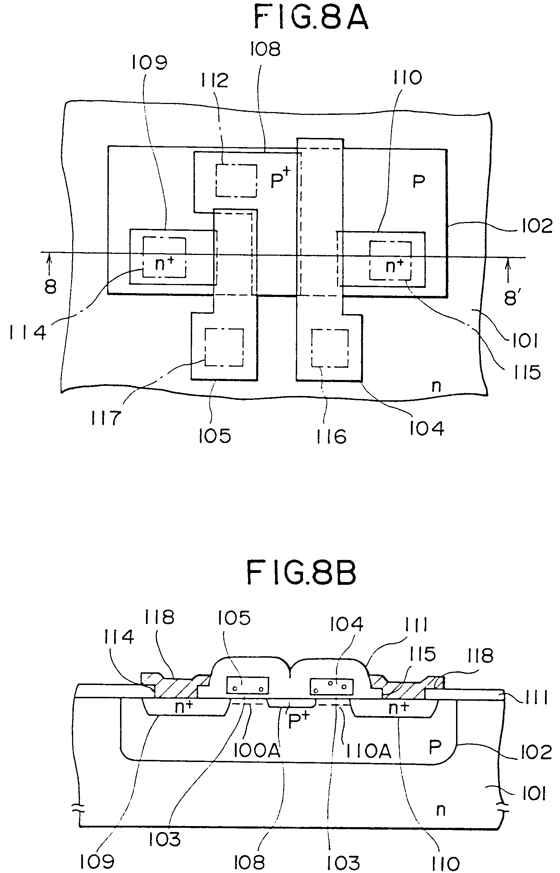

Next, a fourth embodiment of the present invention will be described with reference to FIGS.8(A) and 8(B) wherein FIG.8(A) shows a plan view and FIG.8(B) shows a cross sectional view taken along a cross section 8-8'.

Referring to the drawings, the lateral bipolar transistor of the present embodiment is constructed on a p-type well 102 that in turn is formed in an n-type silicon substrate 101. In correspondence to the upper major surface of the p-type well 102, a diffusion region 108 of the $p^+$-type is formed as a base region, and $n^+$-type diffusion regions 109 and 110 are formed also adjacent to the upper major surface of the n-type well 102 as the emitter contact region and the collector contact region. It should be noted that the emitter contact region 109 and the collector contact region 110 are formed with a separation from the base region 108 such that there is formed an emitter region between the emitter contact region 109 and the base region 108 and a collector region is formed between the collector contact region 110 and the base region 108.

On the upper major surface of the substrate 101, a silicon oxide film 103 having a thickness of about 10 nm is formed, and induction electrodes 104 and 105 of polysilicon are formed on the silicon oxide film 103 in correspondence to the emitter region and the collector region of the lateral bipolar transistor. Further, an insulation layer 111 of silicon oxide or PSG is deposited to cover the upper major surface of the substrate 101 such that the induction electrodes 104 and 105 are buried under the insulation layer 111. In the insulation layer 111, contact holes 114 and 115 are formed in correspondence to the emitter contact region 109 and the collector contact region 110, and an aluminum or polysilicon electrode 118 fills the contact holes 114 and 115. See the plan view of FIG.8(A).

Further, the base region 108 as well as the induction electrodes 104 and 105 extend perpendicularly to the cross section of FIG.8(B) as can be seen in the plan view of FIG.8(A), wherein a contact hole 112 is formed in correspondence to the base region 108, a contact hole 116 is formed in correspondence to the induction electrode 104, and a contact hole 117 formed in correspondence to the induction electrode 105. In the cross sectional view of FIG.8(B), the contact hole 112 is located below the level of the sheet of the drawing, while the contact holes 116 and 117 are formed above the level of the sheet of the drawing.

By applying a suitable positive bias voltage to the induction electrode 105, an inversion layer 109A is formed in correspondence to the emitter region. Similarly, an inversion layer 110A is formed in correspondence to the collector region in response to a positive bias voltage applied to the induction electrode 104. Thereby, a path of the carriers is established between the emitter contact region 109 to the collector contact region 110 via the inversion layer 109A acting as the emitter region, the base region 108, and the inversion layer 110A acting as the collector region. In response to the base voltage applied to the base region 108 via the contact hole 112, the device performs the transistor operation.

Next, the fabrication process of the lateral bipolar transistor of the present embodiment will be described with reference to FIGS.9(A) - 9(D).

Referring to FIG.9(A), the upper major surface of the silicon substrate 101 is subjected to a thermal annealing process to form a silicon oxide film 103a with a thickness of about 100 nm. Further, a polysilicon layer 104a and a silicon oxide layer 106a are deposited consecutively on the silicon oxide film 103a respectively with the thicknesses of about 500 nm and 300 nm.

In the step of FIG.9(B), the silicon oxide film 103a as well as the polysilicon layer 104a and the silicon oxide layer 106a are patterned by the photolithographic process such that a pair of strip-like patterns 119 of the silicon oxide film 103a, the polysilicon layer 104a and the silicon oxide layer 106a are formed. In the cross section of FIG.9(B), the strip-like patterns 119 extend perpendicularly to the sheet of the drawing. It should be noted that the silicon oxide film 103a in the pattern 119 forms the silicon oxide film 103 that supports the induction electrodes 104 and 105, the polysilicon layer 104a in the pattern 119 forms the induction electrode 104 or 105, and the silicon oxide layer 106a in the pattern 119 forms a part of the insulation layer 111 that buries the induction electrodes 104 and 105 underneath.

Further, a photoresist 21 is applied on the structure of FIG.9(B), and after patterning to form a window 21a that exposes the part of the substrate in which the emitter contact region 109 and the collector contact region 110 are to be formed, an ion implantation of phosphorus or arsenic is conducted such that the dopants are incorporated with a dose of $5 \times 10^{15}/cm^2$. After the ion implantation process, the photoresist 21 is removed.

In the step of FIG.9(C), another photoresist 22 is applied and patterned subsequently to form a window 22a that exposes the part of the substrate in which the base region 108 is to be formed. Further, while using the photoresist 22 as the mask, an ion implantation of boron is conducted such that the dopants are incorporated with a dose of $1 \times 10^{13}/cm^2$.

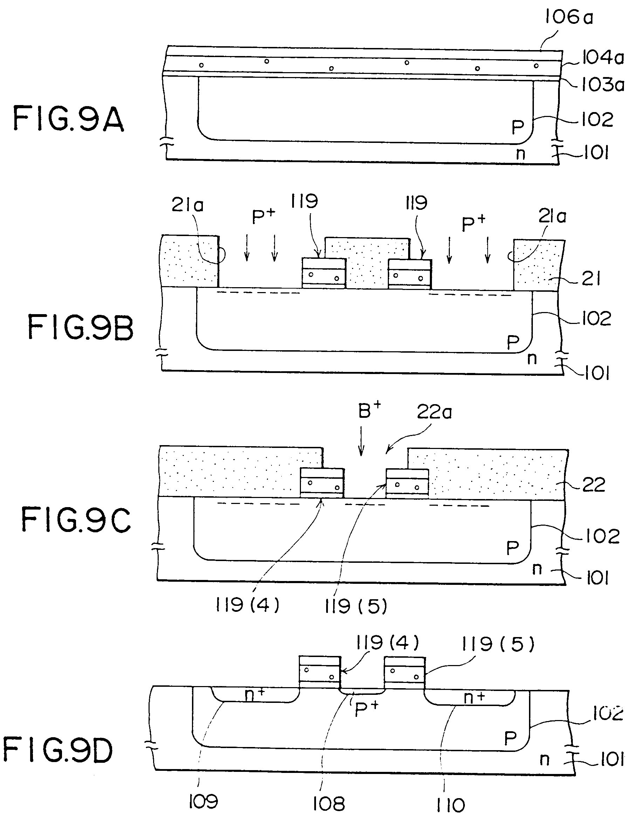

In the step of FIG.9(D), the photoresist 22 is removed and an annealing process is applied to the structure thus obtained. Thereby, the dopants are activated and the diffusion regions are formed in correspondence to the base region 108, the emitter contact region 109 and the collector contact region 110. Thereby, the structure shown in FIG.9(D) is obtained. Further, the insulation layer 111 is deposited to cover the surface of the structure of FIG.9(D), and the contact holes 112, 114, 115, 116 and 117 are formed. See the plan view of FIG.8(A). After filling the contact holes by the electrodes 118, one obtains the device of FIG.8(B).

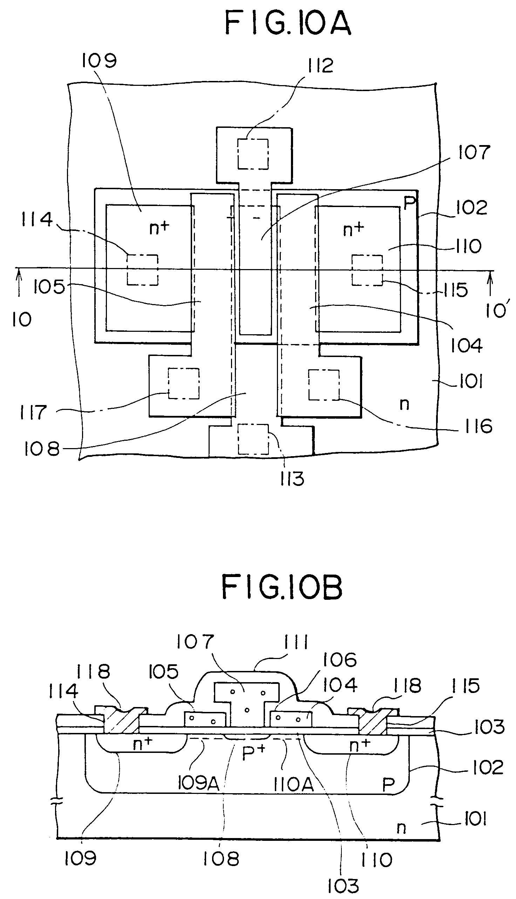

Next, a fifth embodiment of the present invention will be described with reference to FIGS.10(A) and 10(B), wherein FIG.10(A) shows a plan view and FIG.10(B) shows a cross sectional view taken along a cross section 10-10'.

Referring to the drawings, the device of the present embodiment is formed also on the p-type well 102 that is formed in the n-type silicon substrate 101 similar to the previous embodiment. In the well 102, the base region 108, the emitter contact region 109 and the base contact region 110 are formed similarly as before. In the present embodiment, the upper major surface of the substrate 101 is covered entirely by the thin silicon oxide film 103 that has the thickness of about 100 nm.

On the silicon oxide film 103, the induction electrodes 104 and 105 are formed in correspondence to the emitter region and the collector region similar to the previous embodiment. Further, a base control electrode 107 is provided on the upper major surface of the silicon oxide film 103 in correspondence to the base region 108. As shown in the plan view of FIG.10(A), the emitter region 108 extends perpendicular to the cross section 10-10' and a contact hole 113 is provided for the external connection to the emitter region 108. In the cross sectional view of FIG.10(B), the contact hole 113 is provided at a level above the level of the sheet of the drawing. The control electrode 107 extends also in the direction perpendicular to the sheet of the drawing of FIG.10(B), and there is provided a contact hole 112 for external connection at the level below the sheet of FIG.10(B). See also the plan view of FIG.10(A). Other parts of the device of the present embodiment are substantially the same as the previous embodiment and further description about the structural feature will be omitted.

In the present embodiment, the induction electrodes 104 and 105 are biased similar to the previous embodiment. Thereby, the inversion layers 109A and 110A are formed under the induction electrodes 105 and 104 respectively and there is formed a path of carriers similarly to the device of the previous embodiment. Thus, the device shows the transistor operation in response to the base voltage applied to the base region 108 via the contact hole 113.

The present embodiment differs from the previous embodiment of FIGS.8(A) and (B) in the point that the control electrode 107 is provided on the base region 108 via the silicon oxide film 103, and the number of holes in the base region 108 can be modified in response to the voltage applied to the control electrode 107. Thereby, one can modify the amplification factor of the transistor according to the hole density in the base region 108. For example, the hole density is increased when a negative voltage is applied to the control electrode 107. When this occurs, the amplification factor of the transistor increases.

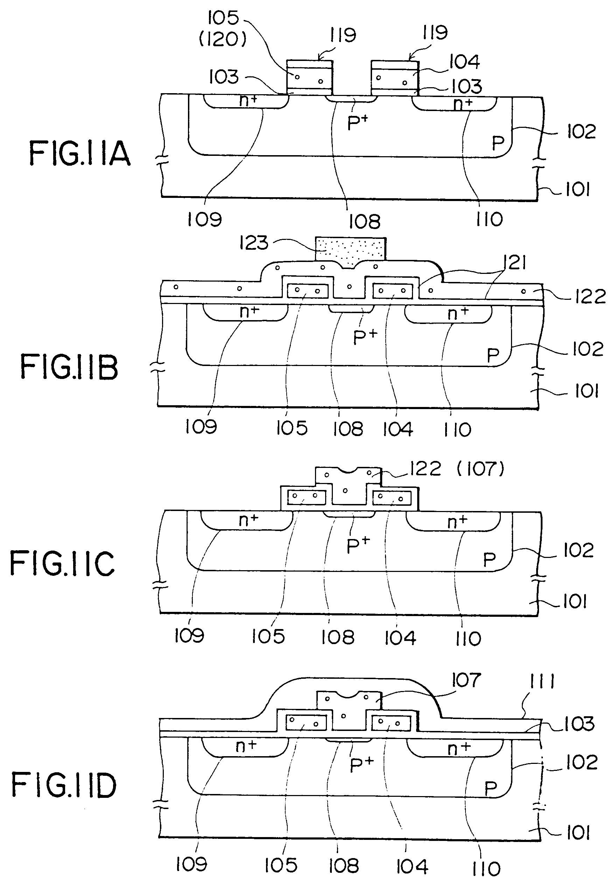

Next, the fabrication process of the transistor of the present embodiment will be described with reference to FIGS.11(A) - 11(D).

Starting from the structure of FIG.11(A) corresponding to the structure of FIG.9(D), a silicon oxide film 121 is formed to cover the surface of the structure of FIG.11(A) with a thickness of about 10 nm as shown in FIG.10(B) by applying a thermal oxidation process under a dry oxygen environment. Further, a polysilicon layer 122 is deposited on the silicon oxide film 121 with a thickness of about 500 nm. Further, the polysilicon layer 122 is subjected to an etching process while protecting a part located between the two electrode structures 119 by a patterned resist mask 123 as shown in FIG.11(B). Thereby, a structure shown in FIG.11(C) is obtained.

Next, the entire structure of FIG.11(C) is covered by the insulation layer 111 of silicon oxide or PSG as shown in FIG.11(D), and after the formation of the contact holes 111, 113, 114, 115 and 116 as shown in the plan view of FIG.10(A), the device of FIG.10(B) is obtained.

In the present embodiment, it is of course possible to use the p-type well 102 itself as the base region 108. In this case, the diffusion region for the base region 108 is not provided. Even in such a case, the control of the hole density in the base region can be achieved via the control electrode 107.

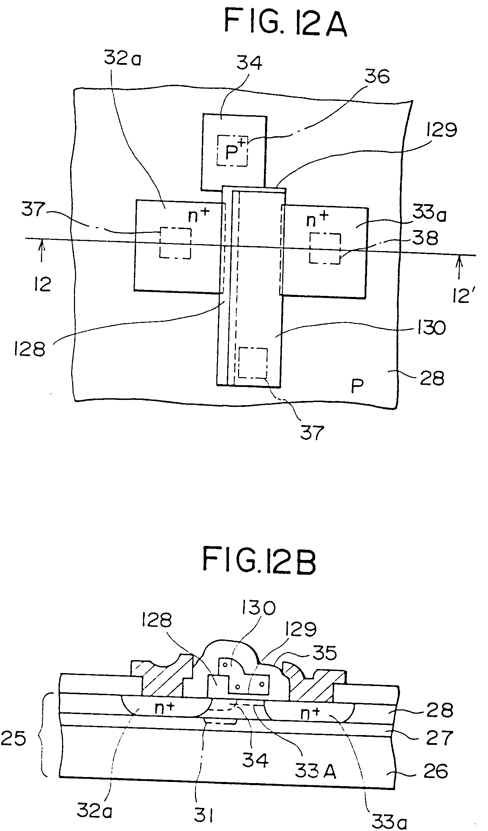

Next, a sixth embodiment of the present invention will be described with reference to FIGS.12(A) and 12(B), wherein FIG.12(A) shows a plan view and FIG.12(B) shows a cross sectional view taken along a cross section 13-13′ of FIG.12(A).

Referring to the drawings, the lateral bipolar transistor of the present embodiment is constructed on the SOI substrate 25 that is used for the first embodiment. In the device layer 28, there are provided diffusion regions 31a and 33a of the $n^+$-type respectively in correspondence to the emitter region and the collector contact region of the bipolar transistor. Thus, the collector contact region 33b corresponds to the diffusion region 33 of FIG.2(B) while there is no suitable corresponding diffusion region in FIG.2(B) for the emitter region 33a.

On the upper major surface of the device layer 28, there is provided a silicon oxide film 129 to cover a part extending between the diffusion region 32a and the diffusion region 33a, wherein the silicon oxide film 129 is formed with a projection 128 in correspondence to a base region that is formed in the device layer 28 adjacent to the diffusion region 32a acting as the emitter region. Further, a polysilicon induction electrode 130 is provided on the silicon oxide film 129 as shown in the cross sectional view of FIG.12(B). As shown in the plan view of FIG.12(A), the electrode 130 extends generally perpendicular to the cross section 12-12′ and has a contact hole 37 at a level above the level of the sheet of the drawing of FIG.12(B). Further, a base contact region is formed as the $p^+$-type diffusion region 34 that is formed in the device layer 28 at the level below the sheet of FIG.12(B) similarly to the first embodiment. Further, a silicon oxide or PSG layer is provided as the insulation layer 35 to bury the induction electrode 130 as well as the projection 128 on the silicon oxide film 129. In correspondence to the emitter region 32a and the collector contact region 33a, the contact holes 37 and 38 are formed similar to the first embodiment.

In operation, a suitable negative bias voltage is applied to the induction electrode 130. Thereby, the induction electrode 130 induces the inversion layer 33A as illustrated in FIG.12(B) while the formation of the inversion layer is interrupted in correspondence to the projection 128. Thereby, the inversion layer 33A acts as the collector region of the lateral bipolar transistor. In the present embodiment, the inversion layer corresponding to the emitter region is not formed, as the emitter region is given by the diffusion region 32a.

As the process for fabrication of the structure of FIGS.12(A) and 12(B) can be derived easily from the description of the first embodiment, the description for the fabrication process will be omitted.

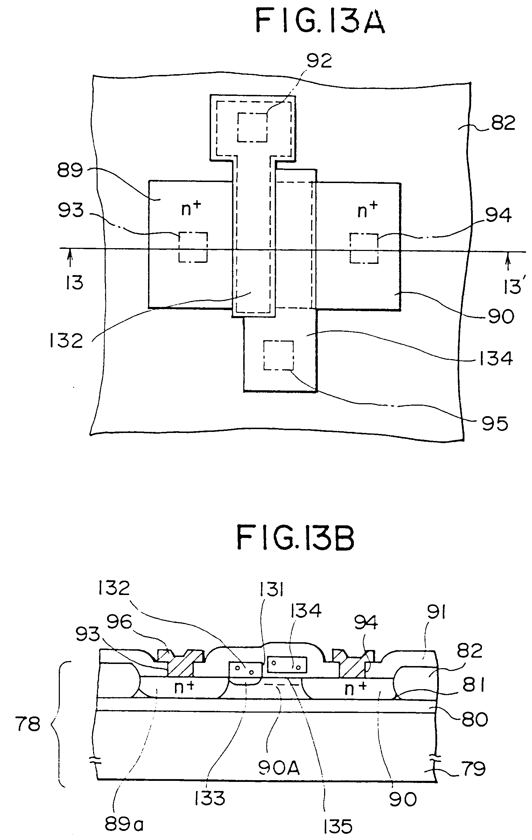

FIGS.13(A) and 13(B) are diagrams showing a seventh embodiment of the present invention, wherein FIG.13(A) represents a plan view and FIG.13(B) represents a cross sectional view taken along a line 13-13′.

The present embodiment is a modification of the embodiment of FIGS.6(A) and 6(B) described previously. Thus the parts that have been described already are designated by the same reference numerals and the description thereof will be omitted.

In the present embodiment, the induction electrode 87 is eliminated and the diffusion region 89 is used for the emitter region itself. Thereby, the formation of the inversion layer 89A for the emitter region of the transistor does not occur. In this construction, too, the transistor operates as the lateral bipolar transistor. As the operation of the transistor is substantially identical with those described previously, further description thereof will be omitted.

In the foregoing sixth and seventh embodiments, it is of course possible to eliminate the formation of the inversion layer for the collector region rather than eliminating the formation of the inversion layer for the emitter region.

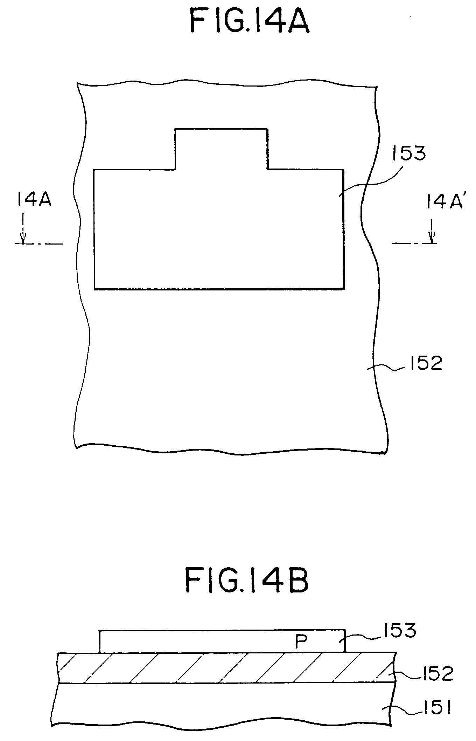

Next, an eighth embodiment of the present invention will be described together with the fabrication process with reference to FIGS.14(A) - 14(H).

Referring to FIGS.14(A) and 14(B), a silicon substrate 151 is subjected to a thermal oxidation process conducted under the wet oxygen environment and a silicon oxide layer 152 is formed with a thickness of about 1 μm. Further, a polysilicon layer of the p-type is deposited on the silicon oxide layer 152 and recrystallized by the zone melting recrystallization (ZMR) process. Thereby a silicon single crystal layer of the p-type is formed on the silicon oxide layer 152 as the device layer with a thickness of 0.5 μm.

Further, the device layer is patterned by the photolithographic process such that an isolated island-like device region 153 of single crystal silicon is formed as shown in the plan view of FIG.14(A). It should be noted that the cross sectional view of FIG.14(B) corresponds to the cross section taken along the line 14A-14A′ of FIG.14(A). As shown in the plan view of F1G.14(A), the device region 153 includes a projected part 153a in which a contact hole is formed in the later process.

Alternatively, the SOI substrate may be formed by bonding a silicon single crystal substrate on the silicon oxide layer 152 as the device layer and subsequently reducing the thickness by lapping. Further, the so-called SIMOX process may be employed.

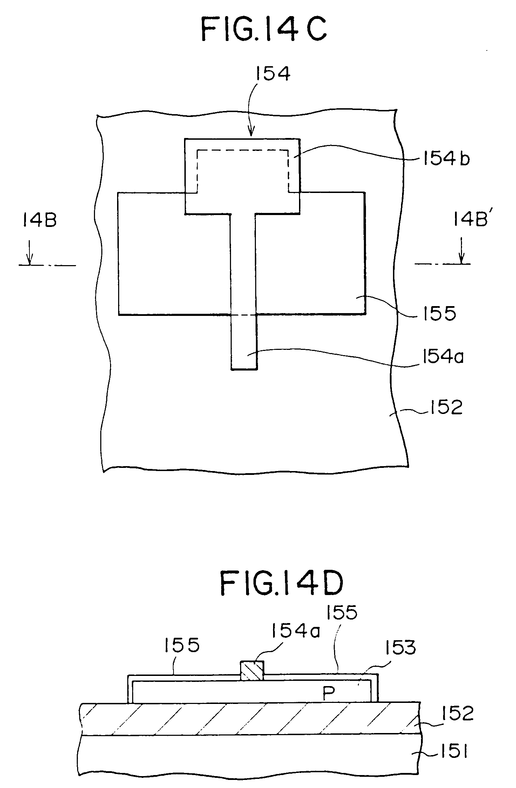

Next, a silicon oxide layer is deposited on the entire surface of the substrate thus obtained by the CVD process and patterned subsequently by the photolithographic process to form a silicon oxide pattern 154 that includes a silicon oxide strip 154a extending and traversing the device region 153 of silicon. As shown in FIG.14(C), the silicon oxide pattern 154 includes a main region 154b that is formed in correspondence to the projected part 153a of the device region 153 in continuation with the silicon oxide strip 154a. Further, the exposed surface of the device region 153 is subjected to a thermal annealing process wherein a silicon oxide film 155 is formed to cover the surface of the device region 153 uniformly with a thickness of about 50 nm. The thickness of the oxide film 155 should be controlled precisely such that the desired inversion layer is formed in the device layer later in the operation of the device. See the cross sectional view of FIG.14(D).

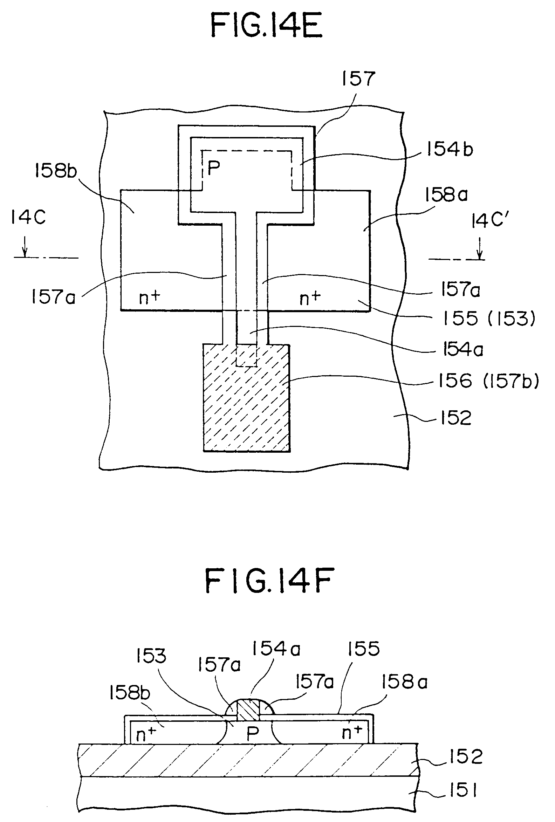

Next, a polysilicon layer is deposited over the entire structure of FIG.14(C) by the CVD process with a uniform thickness of about 0.6 μm, and the polysilicon layer is subjected to an anisotropic etching process that acts perpendicular to the major surface of the polysilicon layer until the upper major surface of the silicon oxide pattern 154 is exposed. The etching may be achieved by using a mixture of $CF_4$ and oxygen as the etching gas. Thereby, a polysilicon pattern 157 is left generally in correspondence to the silicon oxide pattern 154 as shown in FIG.14(E) such that the polysilicon pattern 157 surrounds laterally the silicon oxide pattern 154. It should be noted that the polysilicon pattern 157 includes a pair of side wall regions 157a that cover both side walls of the silicon oxide strip 154a as shown in the cross sectional view of FIG.14(F). Further, at the time of etching, the polysilicon pattern is protected by a photoresist 156 in correspondence to a pad region to be formed and thus, there is formed a pad region 157b in the polysilicon pattern 157. Further, while using the silicon oxide strip 154a and both side wall regions 157a as a mask, an ion implantation of the n-type dopants is conducted to the exposed part of the silicon device region 153. After a heat treatment to activate the dopants thus introduces, an emitter contact region 158a and a collector contact region 158b are formed as the $n^+$-type diffusion region. See the cross sectional view of FIG.14(F).

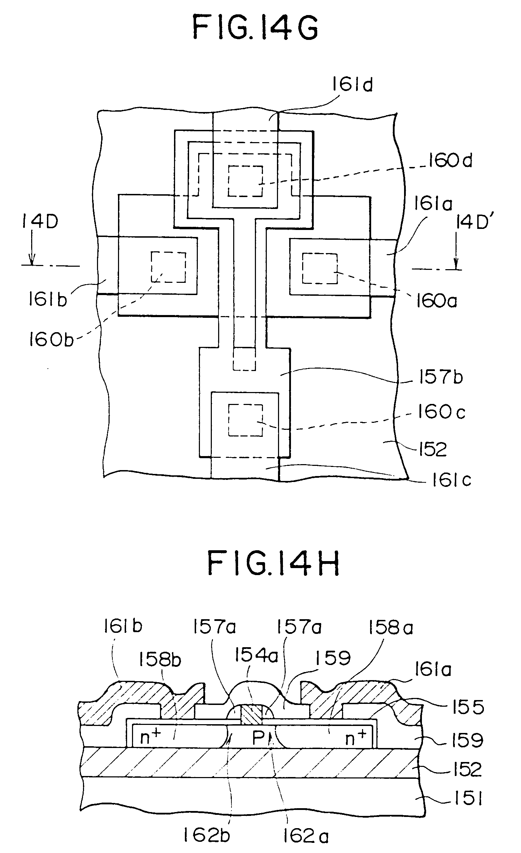

Next, a PSG layer 159 is deposited by the CVD process on the entire surface of the structure of FIGS.14(E) and 14(F) with a thickness of about 1 μm, for example. Further, contact holes 160a - 160d are formed by the usual photolithographic process as shown in FIG.14(G) respectively for a collector electrode 161a, an emitter electrode 161b, a control electrode 161c and a base electrode 161d. The device thus obtained has a cross section shown in FIG.14(H). As usual, the electrodes 161a - 161d may be formed by depositing a layer of aluminum or polysilicon by the sputtering process or other suitable deposition process and subsequent patterning.

In operation of the device of FIG.14(H), a suitable positive bias voltage is applied to the polysilicon pad region 157b via the contact hole 160c. Thereby, inversion layers 162a and 162b are induced in the device region 153 in correspondence to the part located under the polysilicon side wall regions 157a as the collector and the emitter of the bipolar transistor. The diffusion regions 158a and 158b respectively act as the collector contact region and the emitter contact region. In the present embodiment, the lateral thickness of the side wall regions 157a is reduced because of the fabrication process that forms the side wall regions 157a as the regions left at the side walls of the silicon oxide strip part 154a at the time of the anisotropic etching process of FIG.14(F). Thereby, the lateral extension of the inversion layers 162a and 162b is reduced and the emitter resistance and the collector resistance of the transistor is significantly reduced.

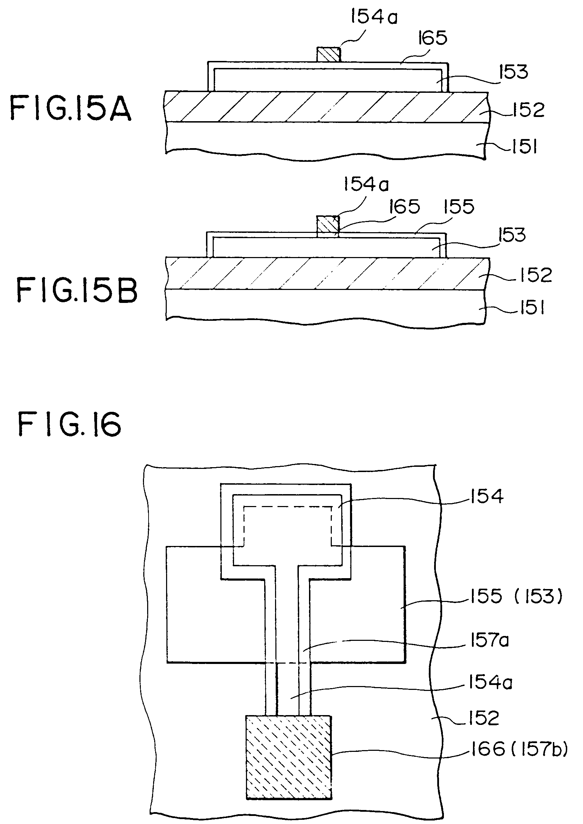

FIGS.15(A) and 15(B) show a modification of the eighth embodiment.

In this modification, a thin silicon oxide film 165 is formed on the surface of the silicon device region 153 previous to the formation of the silicon oxide strip 154a in the step of FIGS.14(C) and 14(D). In this case, therefore, the silicon oxide strip 154a is deposited on the silicon oxide film 165. See FIG.15(A). The silicon oxide film 165 is removed subsequently to the patterning of the silicon oxide strip 154a to avoid any irregularity that may be formed on the surface of the silicon oxide film 165 at the time of patterning of the silicon oxide strip 154a. After the silicon oxide film 165 is entirely removed, the silicon oxide film 155 is formed according to the process described with reference to FIGS.14(C) and 14(D). In this case, the silicon oxide film 165 remains under the silicon oxide strip 154a as shown in FIG.15(B). According to the present process, one can eliminate the variation in the thickness of the silicon oxide film 155 caused at the time of the patterning of the silicon oxide strip 154a.

FIG.16 shows another modification of the eighth embodiment, in which the patterning of the pad region 157b is made while using a photoresist 166 that does not cover a part of the strip-like region 154a in contrast to the photoresist 156 that is used in the step of FIGS.14(E) and 14(F). In this modification, formation of steps on the upper major surface of the pad region 157b can be reduced.

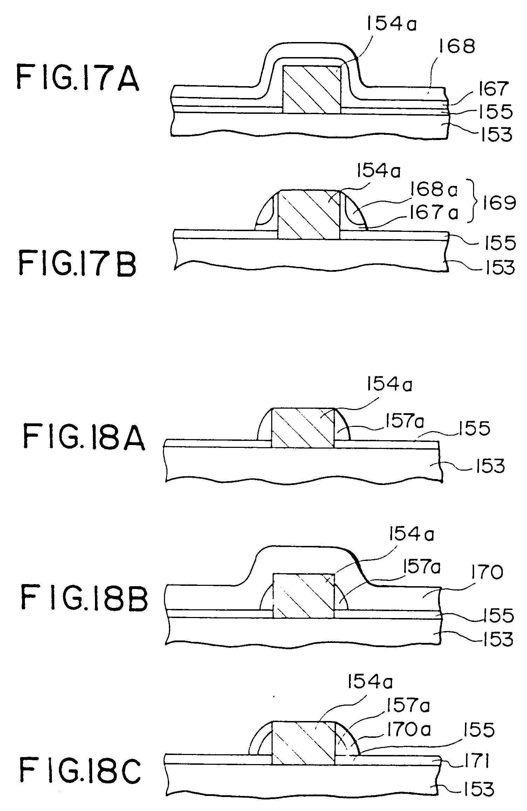

FIGS.17(A) and 17(B) show a still another modification of the eighth embodiment.

In this modification, a polysilicon layer 167 and a silicon oxide layer 168 are deposited consecutively on the structure of FIG.14(D) as shown in FIG.17(A) by the CVD process respectively with thicknesses of 200 nm and 300 nm. After the formation of the layers 167 and 168, an anisotropic etching process acting perpendicular to the upper major surface of the substrate is applied to remove the layers 167 and 168 until the upper major surface of the silicon oxide film 155 is exposed as shown in FIG.17(B). Thereby, a part of the polysilicon layer 167a and a part of the silicon oxide layer 168a are left at the side wall of the silicon oxide strip 154a as a side wall coverage 169. The side wall coverage 169 extends generally perpendicular to the sheet of FIG.17(B) together with the silicon oxide strip 154a. As the lateral boundary of the side wall coverage 169 is defined by the etching of the silicon oxide layer 168a in this construction, one can reduce the irregularity in the shape of the side wall coverage 169 as compared with the embodiment of FIG.14(F).

FIGS.18(A) - 18(C) show another modification of the eighth embodiment. In this modification, the duration of the anisotropic etching in the step of FIG.14(F) is extended. Thereby, the polysilicon pattern 157a left at the side wall of the silicon oxide strip 154a is substantially reduced as shown in FIG.18(A). Next, a silicon oxide layer 170 is deposited to cover the structure of FIG.18(A) as shown in FIG.18(B) by the CVD process with a thickness of about 300 nm. Further, the silicon oxide layer 170 is subjected to an anisotropic etching acting perpendicular to the upper major surface of the device layer 153 until the upper major surface is exposed. Thereby, the polysilicon layer 157a and the silicon oxide layer 170a are left at the side wall of the silicon oxide strip 154a. Further, the exposed upper major surface of the device layer 153 is oxidized such that a silicon oxide film 171 is formed. According to the present construction, one can reduce the unwanted passage of the implanted ions through the marginal part of the polysilicon region that is formed at the side wall of the silicon oxide strip 154a.

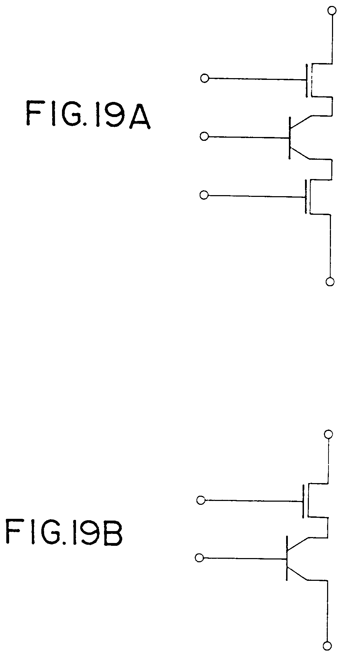

FIGS.19(A) and 19(B) show the equivalent circuit diagrams of the lateral bipolar transistors described heretofore, wherein the circuit diagram of FIG.19(A) corresponds to the embodiments wherein the inversion layer is formed in correspondence to both emitter and collector regions of the bipolar transistor. On the other hand, the circuit of FIG.19(B) corresponds to the embodiment in which the inversion layer is formed in correspondence to one of the emitter and collector regions. In any of these, the current gain of the transistor can be controlled in response to the voltage applied to the gate of the MOS transistor that forms the inversion layer.

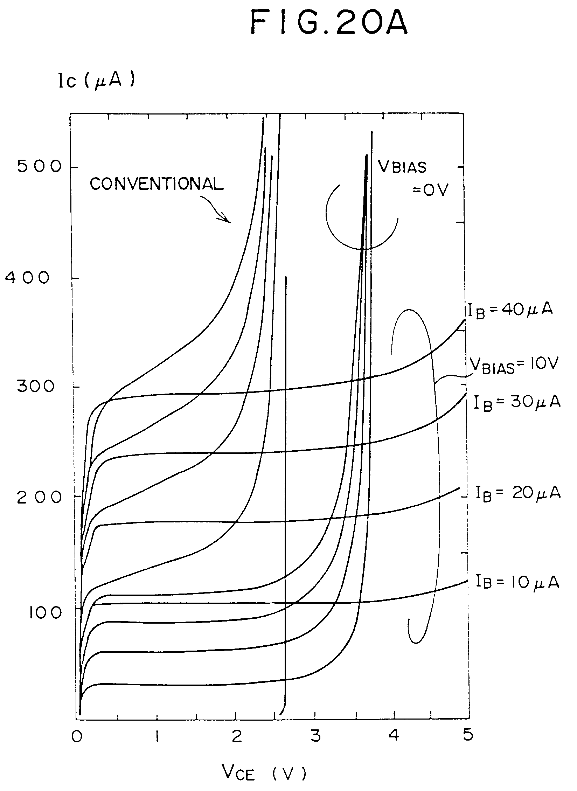

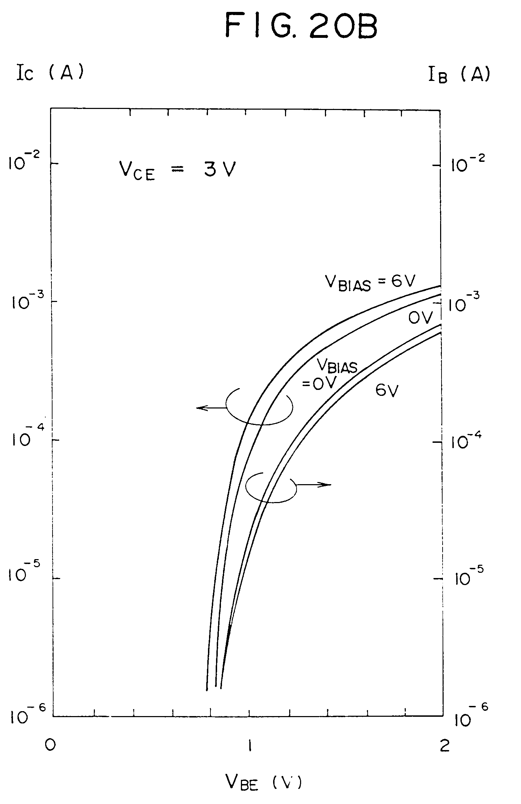

FIGS.20(A) and 20(B) show the operational characteristics of the lateral bipolar transistors of FIGS.2(A) and 2(B), wherein FIG.20(A) shows the Ic-Vc characteristics while FIG.20(B) shows the Gummel plot. In FIG.20(A), the Ic-Vc characteristics for the conventional lateral bipolar transistor is shown for comparison.

The transistor of the present invention has a size W1 (FIG.3(A)) of 1 µm for the projection 29a and a size W2 (FIG.3(C)) of about 2 µm for the insulation structure 29. Further, the projection 29a has a height of 3000 Å, while the insulation film in the structure 29 has a thickness of 300 Å. Further, the polysilicon electrode 30 has a thickness of 5000 Å.

As can be seen in FIG.20(A), the lateral bipolar transistor of the present invention provides very small collector current Ic as compared with the conventional lateral bipolar transistor having the same base thickness, when there is no bias voltage applied to the induction electrode 30. On the other hand, when a bias voltage of about 10 volts is applied to the electrode 30, the lateral bipolar transistor of the present invention provides a collector current Ic that is comparable with the collector current of the conventional lateral bipolar transistor.

As can be seen clearly in FIG.20(A), the lateral bipolar transistor of the present invention has a superior breakdown voltage as compared to the conventional device. From the Gummel plot of FIG.20(B), on the other hand, it can be seen that the application of the bias voltage to the induction electrode 30 is effective in increasing the current gain.

Further, the present invention is not limited to the embodiments described heretofore, but various variations and modifications may be made without departing from the scope of the invention.

## Claims

1. A lateral bipolar transistor, comprising: a device layer (28) of a semiconductor material doped to a first conductivity type, said device layer having upper and lower major surfaces; a first diffusion region (32) having upper and lower major surfaces, said first diffusion region being doped to a second, opposing conductivity type and formed in said device layer such that at least said upper major surface of the first diffusion region is coincident with the upper major surface of the device layer; a second diffusion region (33) having upper and lower major surfaces, said second diffusion region being doped to said second conductivity type and formed in said device layer with a separation from said first diffusion region, said second diffusion region being formed such that at least said upper major surface of the second diffusion region is coincident with the upper major surface of the device layer; and a base region (31) defined in said device layer between said first and second diffusion regions as a part of the device layer with a separation from at least one of the first and second diffusion regions, said base region having upper and lower major surfaces and formed in said device layer such that said upper major surface of the base region is coincident to the upper major surface of the device layer; characterized in that said bipolar transistor further comprises:

an intervening region (32A, 33A) formed in said device layer adjacent to said base region in correspondence to said separation;

control gate means (30) provided on the upper major surface of the device layer in correspondence to said intervening region, said control gate means being supplied with a control voltage and inducing an inversion layer (32A, 33A) in the device layer in correspondence to said intervening region as either of emitter and collector regions, so that there occurs a flow of carriers from the first diffusion region to the second diffusion region passing through the base region and the inversion layer.

2. A lateral bipolar transistor as claimed in claim 1 characterized in that said control gate means comprises an insulation film (129) covering the upper major surface of the device layer (28) at least in correspondence to a part extending between the first diffusion region (32a) and the second diffusion region (33a), and an electrode (130) provided on the insulation film in correspondence to said intervening region for inducing said inversion layer (109A, 110A) in the intervening region in response to a voltage applied thereto.

3. A lateral bipolar transistor as claimed in claim 2 characterized in that said control gate means further comprises a projection (128) of an insulating material provided on the upper major surface of the insulation film in correspondence to said base region to extend in an upward direction.

4. A lateral bipolar transistor as claimed in claim 1 characterized in that said intervening region comprises first and second intervening regions (32A, 33A) formed at both sides of said base region (31), said first intervening region (32A) being formed between the base region (31) and the first diffusion region (32), said second intervening region (33A) being formed between the base region (31) and the second diffusion region (33), said control gate means (30) forming a first inversion layer (32A) in correspondence to the first intervening region as the inversion layer that forms the emitter region of the lateral bipolar transistor and a second inversion layer (33A) in correspondence to the second intervening region as the inversion layer that forms the collector region of the lateral bipolar transistor.

5. A lateral bipolar transistor as claimed in claim 4 characterized in that said control gate means comprises an insulation film (103) formed on the upper major surface of the device layer (81) to extend at least between the first diffusion region (109) to the second diffusion region (110), a first control electrode (105) provided on said insulation film (103) in correspondence to said first intervening region (109A), and a second control electrode (104) provided on said insulation film (103) in correspondence to said second intervening region (110A).

6. A lateral bipolar transistor as claimed in claim 4 characterized in that said control gate means comprises an insulation film (29) having upper and lower major surfaces and provided on the upper major surface of the device layer (28) to cover at least a part of the device layer that is located between said first diffusion region (32) and said second diffusion region (33), a projection (29a) of an insulating material provided on the upper major surface of the insulation film in correspondence to said base region to extend in an upward direction, and an electrode (30) provided on said insulation film to bury said projection underneath for inducing said first and second inversion layers (32A, 33A) in said first and second intervening regions in response to a voltage applied thereto.

7. A lateral bipolar transistor as claimed in claim 4 characterized in that said control gate means comprises a first insulation film (52) having upper and lower major surfaces and provided on the upper major surface of the device layer (50) to cover at least a part of the device layer that is located between said first diffusion region (57) and said second diffusion region (58), a first control electrode (54) provided on the upper major surface of said first insulation film in correspondence to the first intervening region (57A) that is formed between the base region (56) and the first diffusion region (57) for inducing the first inversion layer (57A) in response to a voltage applied thereto, a second control electrode (53) provided on the upper major surface of said first insulation film in correspondence to the second intervening region (58A) for inducing the second inversion layer (58A) in response to a voltage applied thereto, said second control electrode being defined by an upper major surface and a side wall that corresponds to a boundary between the base region (56) and the second intervening region (58A), a second insulation film (55) provided on said first insulation film between said first control electrode and said second control electrode in correspondence to said base region such that said second insulation film extends in an upward direction from the upper major surface of the first insulation film and covers said side wall of the second control electrode.

8. A lateral bipolar transistor as claimed in claim 7 characterized in that said second insulation film (55) extends to cover the upper major surface of the second control electrode (53), and said first control electrode (54) has a form to extend along the second insulation film to form an overhang structure that covers the side wall and at least a part of the upper major surface of the second control electrode.

9. A lateral bipolar transistor as claimed in claim 4 characterized in that said control gate means comprises an insulation film (155) having upper and lower major surfaces and provided on the upper major surface of the device layer to cover at least a part of the device layer that extends between the first diffusion region (158b) and the second diffusion region (158a), a projection (154) of an insulating material formed on and extending along the upper major surface of the insulation film in correspondence to said base region, said projection being defined by a pair of opposing side walls, and first and second control electrodes (157a) provided on the upper major surface of the insulation film respectively along said opposing side walls of the projection and respectively in correspondence to said first and second intervening regions (162b, 162a) for inducing the inversion layers in said first and second intervening regions in response to a control voltage supplied thereto, said first control electrode covering the upper major surface of the insulation film in correspondence to said first intervening region, said second control electrode covering the upper major surface of the insulation film in correspondence to said second intervening region.

10. A lateral bipolar transistor as claimed in claim 2 characterized in that said bipolar transistor further comprises another electrode (107) on the upper major surface of the insulation film in correspondence to the base region (108) in the device layer for causing a modulation in the carrier density in the base region in response to a voltage applied thereto.

11. A lateral bipolar transistor as claimed in claim 2 characterized in that said base region comprises a third diffusion region (108) of the first conductivity type.

12. A lateral bipolar transistor as claimed in claim 1 in which said bipolar transistor further comprises an insulating substrate (27) having upper and lower major surfaces under said lower major surface of the device layer (28), said first and second diffusion regions (32, 33) having the lower major surfaces coincident to the lower major surface of the lower major surface of the device layer.

13. A method for fabricating a lateral bipolar transistor, characterized by the steps of:

forming a first oxide film (68) on an upper major surface of a semiconductor substrate (50);

providing a first electrode (53) on said first oxide film in correspondence to one of emitter and collector regions;

depositing an oxide layer (74) on said first oxide film (75) to bury the first electrode (53) underneath;

applying an anisotropic etching process acting substantially perpendicular to the upper major surface of the device layer to expose the upper major surface of the substrate (50), said anisotropic etching being made to leave a part of said oxide layer (74a) at a side wall of the first electrode (53) in correspondence to a base region (56) of the lateral bipolar transistor;

forming a second oxide film (75) to cover the exposed upper major surface of the substrate (50);

depositing a conductor layer (76) such that the conductor layer at least covers said oxide layer that is remaining at the side wall of the first electrode;

patterning the conductor layer (76) to form a second electrode (76) such that the second electrode covers the second oxide film (75) in correspondence to the other of emitter and collector regions of the lateral bipolar transistor; and

implanting impurities into the substrate while using the first and second electrodes (53, 76) as a mask.

14. A method for fabricating a lateral bipolar transistor, characterized by the steps of:

providing an insulation region on an upper major surface of a semiconductor substrate (153) of a first conductivity type in correspondence to a base region of the transistor as a strip-like region (154a) defined by a pair of opposing side walls;

covering the upper major surface of the substrate not covered by the strip-like region by a first oxide film (155);

depositing a conducting material on an upper major surface of said first oxide film (155) including said strip-like region (154a) such that said strip-like region is buried underneath the conducting material;

patterning the conducting material by applying an anisotropic etching process that acts substantially perpendicular to the upper major surface of the substrate (153) to remove the conducting material from the upper major surface of the first oxide film (155) except for the side walls of the strip-like region (154a), said step of patterning including a formation of a bonding pad region (157b) in connection to the part of the conducting material (157a) left at the side walls of the strip-like region (154a);

conducting an ion implantation process while using the strip-like region (154a) and the conducting material (157a) left at the side walls of the strip-like region as a mask to form diffusion regions of a second, opposite conductivity type at both sides of the strip-like region as emitter and collector regions.

15. A method as claimed in claim 14 characterized in that said method comprises a step of forming a second oxide film (165) to cover the upper major surface of the substrate (153) before the step of providing the strip-like insulation region (154a), and a step of removing the second oxide film (165) to expose the upper major surface of the substrate (153) except for those located under the strip-like insulation region (154a), after the step of forming the strip-like insulation region (154a) but before the step of forming the first oxide film (155).

16. A method as claimed in claim 14 characterized in that said step of patterning of the conducting material includes a step of covering the conducting material in correspondence to the bonding pad region (157b) by a photoresist (156).

17. A method as claimed in claim 14 characterized in that said photoresist (156) is provided to cover a part of said strip-like insulation region (154a) in the step of patterning the conducting material.

18. A method as claimed in claim 16 characterized in that said photoresist (166) is provided adjacent to and in contact with an end of said strip-like insulation region (154a).

19. A method as claimed in claim 16 characterized in that said step of patterning the conducting material comprises a step of depositing a third oxide film (168) on an upper major surface of the conducting material (167) before the anisotropic etching, said anisotropic etching being achieved to remove the third oxide film together with the conducting material except for a part that is remaining on the conducting material that covers the side wall of the strip-like region (154a).

# FIG.1 PRIOR ART

# FIG.2A

# FIG.2B

FIG.3A

FIG.3B

FIG.3C

FIG.3D

# FIG. 4A

# FIG. 4B

FIG.5 A

FIG.5 B

FIG.5 C

FIG.5 D

EP 0 474 564 A1

FIG.5E

FIG.5F

FIG.5G

## FIG. 6A

## FIG. 6B

**FIG.7A**

85 83 97 (84)
82
81
80
79
78

**FIG.7B**

100 100
98
99
82
81
80
79
85 97(84)

**FIG.7C**

98(87) 84A 99
P+ 98(86) P+
82
81
80
85 97(84) 85
79

**FIG.7D**

89 98(87) 99 90
n+ P+ n+
82
81
80
85 88 85
79

# FIG.8A

# FIG.8B

FIG.9A

FIG.9B

FIG.9C

FIG.9D

# FIG.IOA

109   112   107   102   114   110   105   115   10'   10   104   101   117   108   116   113

n+   n+   P   n

# FIG.IOB

107   111   118   105   106   118   115   114   104   103   102   101   n+   P+   n+   P   109A   110A   n   109   108   110   103

FIG.11A

105
(120)    119         119
103                          104
         n+                  103
              P+
                        P        102
                                 101
109          108         110

FIG.11B

123                      121
                              122
         n+        P+    n+
                        P    102
                             101
109   105   108   104   110

FIG.11C

122 (107)
         n+              n+
              P+
                        P    102
                             101
109   105   108   104   110

FIG.11D

107        111
                   103
         n+              n+
              P+        102
                        P
                             101
109   105   108   104   110

# FIG. 12A

# FIG.12B

## FIG.13A

## FIG.13B

# FIG.14A

153

14A

14A'

152

# FIG.14B

P

153

152

151

# FIG.14 C

154

154b

14B

14B'

155

154a

152

# FIG.14 D

155

154a

155

153

155

P

152

151

# FIG.14E

# FIG.14F

# FIG.14G

161d

160d

14D

161a

14D'

161b

160a

160b

157b

160c

152

161c

# FIG.14H

161b 157a 157a 158a

158b 154a 159 161a

155

n+ P n+ 159

152

151

162b 162a

FIG.15A

FIG.15B

FIG.16

FIG.17A

154a
168
167
155
153

FIG.17B

154a
168a
167a } 169
155
153

FIG.18A

154a
157a
155
153

FIG.18B

154a
157a
170
155
153

FIG.18C

154a
157a
170a
155
171
153

FIG.19A

FIG.19B

# FIG.20A

# F I G. 20B

**European Patent Office**

## EUROPEAN SEARCH REPORT

Application Number

EP  91 40 2393

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN<br>vol. 12, no. 189 (E-616)2 June 1988<br>& JP-A-62 293 768 ( MATSUSHITA ) 21 December 1987<br>* abstract * | 1-3 | H01L29/73<br>H01L21/331 |
| Y | | 12 | |
| Y | IEEE ELECTRON DEVICE LETTERS.<br>vol. 4, no. 8, August 1983, NEW YORK US<br>pages 269 - 271;<br>B-Y. TSAUR: 'Fully Isolated Lateral Bipolar-MOS Transistors Fabricated in<br>Zone-Melting-Recrystallized Si Films on SiO2' | 12 | |
| A | EP-A-0 311 419 (FUJITSU)<br>* abstract * | 1 | |
| | | | **TECHNICAL FIELDS SEARCHED (Int. Cl.5)**<br><br>H01L |

The present search report has been drawn up for all claims

| Place of search | Date of completion of the search | Examiner |
|---|---|---|
| THE HAGUE | 26 NOVEMBER 1991 | Peter Niles |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)